# DEMANDE DE BREVET EUROPEEN

(11) **EP 0 752 810 A1**
(43) Date de publication de la demande: **08.01.1997**
(21) Numéro de dépôt: 96401282.7
(22) Date de dépôt: 13.06.1996
(51) Int. Cl.: H05K 9/00

(54) **Procédé de blindage électromagnétique d'un panneau composite et panneau obtenu par ce procédé**

(30) Priorité: 06.07.1995 FR 9508166
(71) Demandeur: ETAT FRANCAIS Représenté par le Délégué Général pour l'Armement, 75007 Paris 7ème (FR)
(72) Inventeur: Le Lan, Jean Yves, 56270 Ploemeur (FR); Le Foulgoc, Jean Marc, 56850 Caudan (FR); Nadaud, Didier, 56260 LARMOR PLAGE (FR); Vincent, Olivier, 29100 Douarnenez (FR)

(57) **Abrégé**

L'invention concerne un procédé de fabrication d'un panneau composite monolithique ou de type sandwich organisé autour d'une âme, muni d'un blindage électromagnétique, caractérisé par les étapes successives suivantes :
- réalisation d'au moins un empilement ou pli (2) formé par une couche de résine ou de tissu préimprégné, puis une couche de tissu de fibres sec et enfin une couche de résine ou de tissu préimprégné,
- pour un panneau de type sandwich, pose de l'âme (1), dépôt sur l'âme (1) d'au moins un empilement ou pli (2) formé par une couche de résine ou de tissu préimprégné, puis une couche de tissu de fibres sec et enfin une couche de résine ou de tissu préimprégné,
- pose d'un grillage métallique (4),
- polymérisation.

L'invention concerne également un panneau composite obtenu selon ce procédé, caractérisé en ce que le blindage électromagnétique est obtenu par un grillage métallique (4) positionné sur les couches de constitution du panneau.

## Description

L'invention concerne un procédé de blindage électromagnétique d'un panneau composite ainsi qu' un panneau obtenu par ce procédé.

Les panneaux selon l'invention sont destinés principalement au revêtement de plafonds, cloisons latérales, sols de navires.

Les matériaux composites sont intrinsèquement transparents aux rayonnements électromagnétiques.

Lorsque des locaux techniques dont les cloisons, les plafonds et les sols sont constitués de panneaux de matériau composite, abritent des équipements électroniques sensibles de communication et de contrôle, tels que des radars de navigation, il est nécessaire d'équiper de blindages électromagnétiques les panneaux.

Classiquement, la réalisation d'un blindage électromagnétique sur une structure composite peut s'effectuer par "shoopage" ou projection d'un métal en fusion tel qu' un alliage zinc-aluminium au moyen d'un pistolet oxyacétylénique.

L'élévation importante de la température du panneau qui résulte de la projection est cependant susceptible d'endommager gravement la matière composite.

En oûtre, ce procédé ne permet pas la continuité du blindage dans les angles et nécessite la mise en place de plots de connexion internes.

Le "shoopage" a une tenue mécanique insuffisante qu'il convient d'améliorer par la pose d'une couche de tissu stratifié de grammage faible, ce qui augmente alors le poids du panneau.

Un blindage électromagnétique peut aussi être obtenu par la pose d'un tissu grillagé métallique ou d'un feuillard de cuivre que l'on fixe sur la face concernée des panneaux par l'intermédiaire de plots. Ce procédé est long à mettre en oeuvre pour un très grand nombre de panneaux; c'est le cas lorsque la structure composite présente des jonctions de panneaux et des raidisseurs.

L'utilisation de fibres de carbone ou de résine conductrice présente les mêmes inconvénients aux jonctions de panneaux.

Le but de l'invention est donc d' obtenir un panneau muni d'un blindage électromagnétique, conservant ses caractéristiques mécaniques en température, qui soit facile à fabriquer et à assembler, et qui n'entraîne pas d' augmentation considérable de la masse du panneau.

L'invention a donc pour objet un procédé de fabrication d'un panneau composite monolithique ou de type sandwich organisé autour d'une âme, muni d'un blindage électromagnétique, caractérisé par les étapes successives suivantes :
- réalisation d'au moins un empilement ou pli formé par une couche de résine ou de tissu préimprégné, puis une couche de tissu de fibres sec et enfin une couche de résine ou de tissu préimprégné,
- pour un panneau de type sandwich, pose de l'âme, dépôt sur l'âme d'au moins un empilement ou pli formé par une couche de résine ou de tissu préimprégné, puis une couche de tissu de fibres sec et enfin une couche de résine ou de tissu préimprégné,
- pose d'un grillage métallique,
- polymérisation.

L'invention a également pour objet un panneau composite monolithique ou de type sandwich organisé autour d'une âme, muni d'un blindage électromagnétique, caractérisé en ce que le blindage électromagnétique est obtenu par un grillage métallique positionné sur les couches de constitution du panneau.

De préférence, le grillage métallique est une toile de laiton.

Dans un mode de réalisation préférentiel d'un panneau composite en structure sandwich, l'âme est en balsa et peut être prénourrie de résine.

Une couche de mat d'accrochage peut être disposée de part et d'autre de l'âme.Cette couche a de préférence un grammage de 150 g/m2.

Dans un autre mode de réalisation préférentiel, le tissu préimprégné est à base de fibres de verre et de résine époxy et peut être bidirectionnel(0°,90°).

Une couche isolante pouvant être un adhésif autodémoulant, ou bien être constituée de mylar ou de feutre, peut séparer le grillage métallique de la dernière couche de constitution du panneau composite, notamment aux extrêmités qui doivent rester libres pour les assemblages de panneaux.

Le panneau composite monolithique ou de type sandwich organisé autour d'une âme, muni d'un blindage électromagnétique selon l'invention peut être renforcé et présenter des raidisseurs munis de grillages métalliques pour le blindage électromagnétique.lls sont en matériau composite, intégrés au panneau par stratification de contact ou par collage.

Les extrêmités du grillage des raidisseurs sont isolées de la même manière que précédemment pour permettre l'intégration des raidisseurs aux panneaux.

Le grillage des raidisseurs est relié au grillage du panneau par pliage et soudage.

Deux panneaux composites munis d'un blindage électromagnétique selon l'invention peuvent être assemblés par des jonctions planes grâce à des couches supplémentaires de tissu préimprégné disposées en gradin à la jonction, les extrêmités des grillages des deux panneaux composites étant pliées et jointes par soudure.

Lorsque deux panneaux composites munis d'un blindage électromagnétique selon l'invention forment entre eux un angle, ils sont assemblés grâce à des couches supplémentaires de tissu préimprégné disposées en cornière à la jonction, les extrêmités des grillages des deux panneaux composites étant pliées et jointes par soudure.

Le procédé et le panneau selon l'invention trouvent leur application dans le blindage électromagnétique de locaux techniques.

D'autres caractéristiques de la présente invention apparaitront à la lecture de la description suivante d'un mode de réalisation préférentiel, donné à titre illustratif et non limitatif, et des figures annexées dans lesquelles :
- la figure 1 représente un panneau composite en structure sandwich muni d'un blindage électromagnétique selon l'invention;
- la figure 2 représente le même panneau composite en cours de fabrication;
- la figure 3 représente la jonction plane de deux panneaux composites;
- la figure 4 représente la jonction de deux panneaux composites formant entre eux un angle.

Les structures en matériau composite sont de deux types: les structures monolithiques et les structures sandwich.

Les structures monolithiques consistent en un empilement de couches de matériaux de renforts, tels que fibres de verre, de carbone ou d'aramide et de couches de résines. Elles sont obtenues par polymérisation des différentes couches ou stratification au contact.

La fibre de verre est couramment utilisée parce qu'elle possède une bonne tenue mécanique et thermique ainsi qu'une bonne résistance à l'humidité et à la corrosion.

Les résines les plus employées sont les résines polyester et époxy.

Dans les structures sandwich, une âme est insérée entre deux peaux minces monolithiques afin d'augmenter la rigidité du matériau.

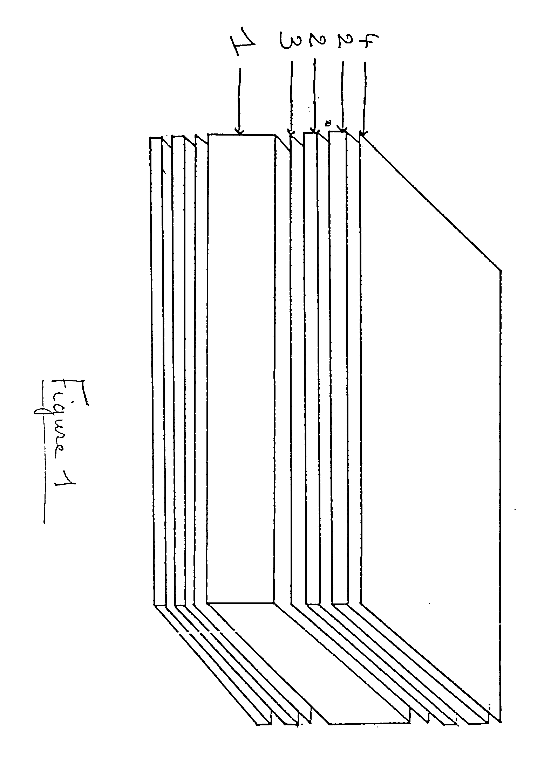

Le mode de réalisation représenté sur la figure 1 concerne une structure sandwich.

De préférence, l'âme est en balsa de masse volumique 100 à 150 kg/m3.

Dans un mode de réalisation préférentiel, l'âme est prénourrie de résine. Sa porosité est réduite et elle a une bonne résistance au collage.

Dans un mode de fabrication connu, une peau monolithique est formée par stratification de contact. Une première couche de tissu de fibres sec est posée au fond d'un moule. Le moule permet d'obtenir des panneaux plans d'une longueur de 25 mètres sur une largeur de 15 mètres.

La première couche est ensuite imprégnée de résine liquide, comprimée et ébullée. Elle est recouverte d'autant de couches de tissus de fibres sec et de résine qu'il est nécessaire pour obtenir une peau à l' épaisseur désirée.

L'âme en balsa est ensuite déposée et collée sous vide.

La seconde peau est ensuite stratifiée sur l'âme en balsa de manière identique à la première.

Dans un mode de réalisation préférentiel, on utilise à la place de la résine liquide, un matériau composite préimprégné, qui est un produit semifini constitué de renforts et d'une résine et qui permet une mise en oeuvre directe.

Le matériau préimprégné peut être sous forme d'une nappe de masse volumique comprise entre 100 à 200 g/m2 ou d'un tissu de masse volumique de 100 à 1000 g/m2.

De préférence, le tissu préimprégné est à base de fibres de verre et de résine époxy.

La manipulation des matériaux préimprégnés est aisée, grâce à leurs revêtements protecteurs pelables au moment de la mise en oeuvre.lls doivent cependant être conservés à des températures basses comprises entre -18°c et -4°c et être étuvés avant utilisation.

Les matériaux préimprégnés évitent la manipulation de résine liquide et ils présentent l'avantage de donner au matériau composite final un taux de fibres plus important.

De préférence, le tissu préimprégné est bidirectionnel équilibré (0°,90°) parce qu'il permet un repérage des fibres. Pour une application du matériau à la réalisation de structures de navires, les fibres à 0° sont orientées par exemple dans l'axe de la poutre du navire.

La structure sandwich représentée sur la figure 1 résulte de l'empilement de couches de tissus préimprégnés de part et d'autre d'une âme 1 en balsa.

La peau inférieure est réalisée par une succession d' empilements ou plis 2 formés chacun par une couche de tissu préimprégné, puis une couche de tissu de fibres sec et enfin une couche de tissu préimprégné.

Le nombre de plis est fonction de l'épaisseur voulue.Deux plis sont représentés sur la figure1. Un seul pli peut parfois être suffisant.

On procède ensuite à la pose de l'âme en balsa.

Plusieurs compactages sont nécessaires pour bien imprégner les couches de tissu sec pendant le drapage, notamment lors de la dépose du mat sur la première peau. Le compactage est obtenu à l'aide d'une poche à vide.

La peau supérieure est réalisée de la même manière que la peau inférieure.

Dans une variante de réalisation, on dépose une couche 3 de mat d'accrochage sec de grammage de préférence 150 g/m2 de part et d'autre de l'âme en balsa. Avant la pose de la seconde peau, le mat sera au préalable fixé au balsa par quelques points de colle, de façon à obtenir une adhérence suffisante de la deuxième peau sur l'âme en balsa avant le compactage.

Les tissus préimprégnés se drapent facilement à la verticale.

Avant polymérisation ou cuisson, on juxtapose sur le dernier pli un grillage 4 pouvant être en toile de laiton.

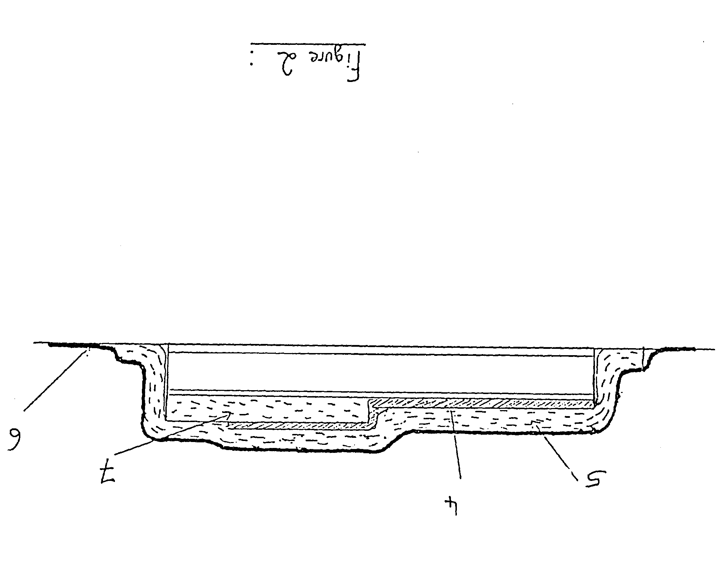

Un compactage est aussi nécessaire pendant le cycle de cuisson en étuve, qui présente deux paliers à 80°C et à 120°C, obtenus par montée progressive en température. Pendant le compactage, la grille est isolée de la poche à vide 6 par une couche 5 visible sur la figure 2 et pouvant être un feutre de drainage ou un adhésif autodémoulant tenant à la température de polymérisation du panneau composite.

Certaines parties du grillage, notamment les extrêmités qui interviennent dans l'assemblage des panneaux, sont isolées du tissu préimprégné par une couche 7 pouvant être constituée par un adhésif autodémoulant tenant à la température de polymérisation du panneau composite. Cette couche isolante peut aussi être en mylar ou en feutre.

La grille en contact avec le tissu préimprégné se colle sur la peau supérieure pendant la cuisson, sauf aux endroits séparés du tissu imprégné par une couche isolante.

Dans un but de renforcement, les panneaux présentent des raidisseurs fabriqués par stratification de couches de tissus de fibres au contact de résine ou bien par stratification de couches de tissus de fibres au contact de couches de tissus préimprégnés.

Quelque soit la technique de réalisation utilisée , les raidisseurs peuvent être stratifiés directement sur les panneaux et dans ce cas, ils sont fixés sur les panneaux avant leur cuisson, même si les panneaux ont déjà suivi un cycle de cuisson.

Les raidisseurs peuvent aussi être réalisés séparément puis collés par la suite sur les panneaux. La colle doit posséder un temps d'ouverture suffisant et être compatible avec les matériaux employés. Le positionnement des raidisseurs sur les panneaux est réalisé à l'aide de vis autotaraudeuses, fixées le long des raidisseurs et qui exercent une pression au collage.

La pression nécessaire au collage peut aussi être obtenue par un dispositif de vérins adaptables à toutes les formes de raidisseurs.

Les raidisseurs sont aussi munis de grillages métalliques assurant le blindage électromagnétique.

Les extrêmités du grillage qui interviennent dans l'assemblage des raidisseurs avec les panneaux, sont isolées du tissu préimprégné par une couche identique à la couche 7 décrite plus haut, pouvant être constituée par un adhésif autodémoulant, du mylar ou du feutre.

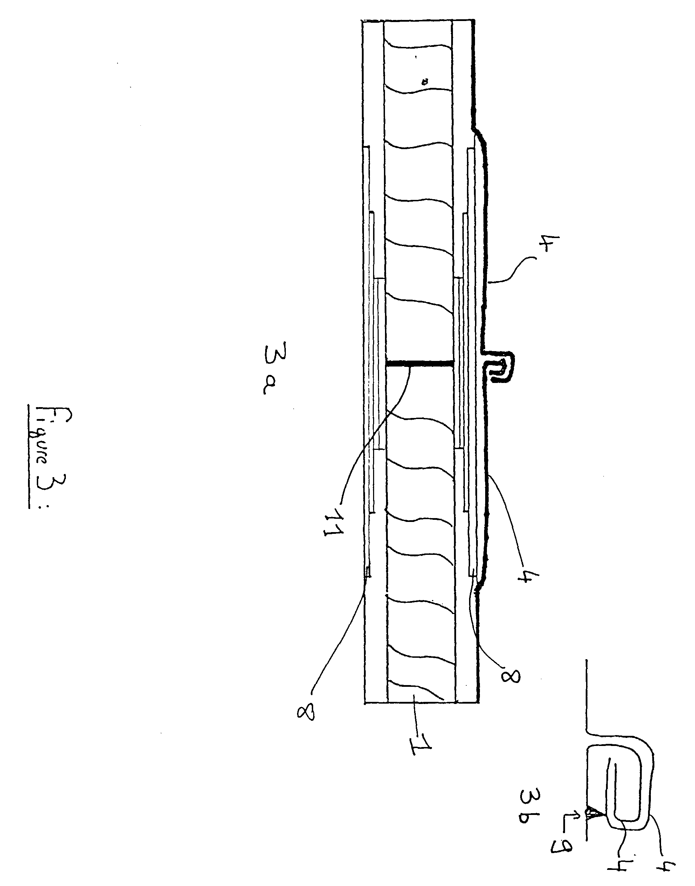

La jonction du grillage du panneau composite avec le grillage du raidisseur est une jonction plane élaborée par pliage et soudage de la manière indiquée sur la figure 3b.

La réalisation de superstructures résulte de l'assemblage de panneaux préfabriqués.Les panneaux assemblés dans un même plan font l'objet d'une jonction plane, comme représentée sur la figure 3a. La jonction plane est obtenue à l'aide de couches supplémentaires de tissus imprégnés 8 disposées en gradin sous le grillage 4. Les âmes en balsa des panneaux sont assemblées par un joint de colle 11.

Du fait de la taille de la structure, la cuisson est réalisée au moyen de tapis chauffants ou de panneaux radiants.

Dans le cas de jonction de panneaux, les extrêmités de grillage 4 ne sont pas collées et sont jointes à l'aide d'un pliage et d'une soudure à l'étain 9 visible sur la figure 3b.

Ces jonctions planes sont rencontrées lors de la réalisation de bordés, de toits, de ponts.

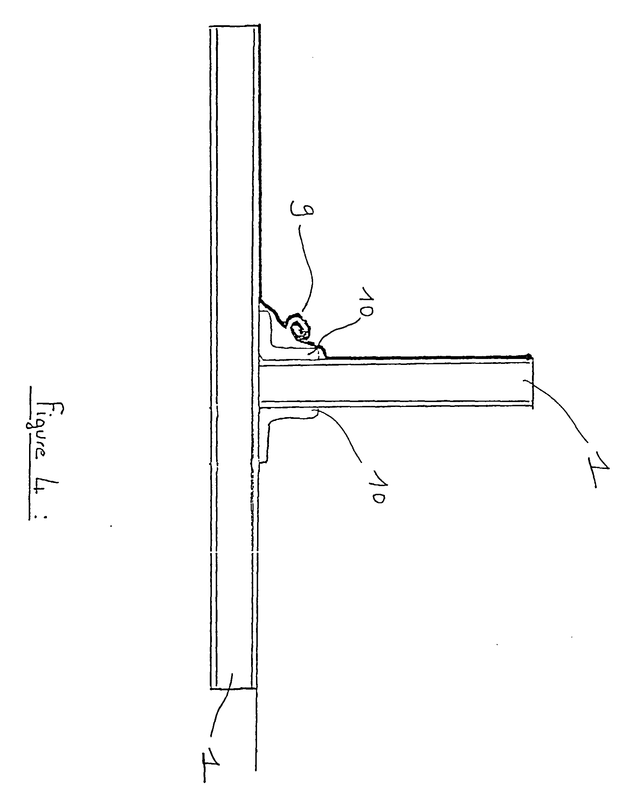

On peut aussi assembler des panneaux qui ne sont pas situés dans un même plan;ils font l'objet de jonctions par cornièrage représentées sur la figure 4. Des cornières 10 sont obtenues par stratification de contact.

Les extrêmités des grillages 4 sont ici encore pliées et jointes à l'aide d'une soudure à l'étain 9.La soudure est intégrée au corniérage par compactage ou collée sur le corniérage.

Ce type de jonction est rencontré lors d'assemblages de cloisons intérieures avec des ponts ou lors d'assemblages de ponts avec des bordés.

Les mailles du grillage assurant le blindage électromagnétique sont fines, de l'ordre de 200 µm pour les plafonds et les cloisons latérales. Elles ont une ouverture plus grande, de l'ordre de 630 µm pour les sols qui doivent être plus résistants.

Après que l'intérieur d'un local ait été équipé de panneaux munis de blindages électromagnétiques selon l'invention, le blindage est relié au réseau de masse général.

Les ouvertures permanentes, telles que les orifices de ventilation doivent être blindées avec des grillages métalliques ou nids d'abeilles.

Les portes et autres panneaux ouvrants sont aussi recouverts d'un matériau de blindage, pour assurer la continuité. Les câbles, gaines de ventilation et tuyaux sont reliés en leur point d'entrée à la masse du local, afin que le local soit entièrement protégé.

## Revendications

1. Procédé de fabrication d'un panneau composite monolithique ou de type sandwich organisé autour d'une âme, muni d'un blindage électromagnétique, caractérisé par les étapes successives suivantes :
- réalisation d'au moins un empilement ou pli (2) formé par une couche de résine ou de tissu préimprégné, puis une couche de tissu de fibres sec et enfin une couche de résine ou de tissu préimprégné,
- pour un panneau de type sandwich, pose de l'âme (1), dépôt sur l'âme (1) d'au moins un empilement ou pli (2) formé par une couche de résine ou de tissu préimprégné, puis une couche de tissu de fibres sec et enfin une couche de résine ou de tissu préimprégné,
- pose d'un grillage métallique (4),
- polymérisation.

2. Panneau composite monolithique ou de type sandwich organisé autour d'une âme, muni d'un blindage électromagnétique selon le procédé de la revendication 1, caractérisé en ce que le blindage électromagnétique est obtenu par un grillage métallique (4) positionné sur les couches de constitution du panneau.

3. Panneau composite monolithique ou de type sandwich organisé autour d'une âme, muni d'un blindage électromagnétique selon le procédé de la revendication 2, caractérisé en ce que le grillage métallique (4) est une toile de laiton.

4. Panneau composite de type sandwich organisé autour d'une âme, muni d'un blindage électromagnétique, selon l'une des revendications 2 ou 3, caractérisé en ce que l'âme (1) est en balsa.

5. Panneau composite de type sandwich organisé autour d'une âme, muni d'un blindage électromagnétique, selon la revendication 4, caractérisé en ce que le balsa est prénourri de résine.

6. Panneau composite de type sandwich organisé autour d'une âme, muni d'un blindage électromagnétique, selon l'une des revendications 2 à 5, caractérisé en ce qu' une couche de mat d'accrochage (3) est disposée de part et d'autre de l'âme.

7. Panneau composite de type sandwich organisé autour d'une âme, muni d'un blindage électromagnétique, selon la revendication 6, caractérisé en ce que la couche de mat d'accrochage (3) a un grammage de 150 g/m2.

8. Panneau composite monolithique ou de type sandwich organisé autour d'une âme, muni d'un blindage électromagnétique, selon l'une des revendications 2 à 7, caractérisé en ce que le tissu préimprégné est à base de fibres de verre et de résine époxy.

9. Panneau composite monolithique ou de type sandwich organisé autour d'une âme, muni d'un blindage électromagnétique, selon la revendication 8, caractérisé en ce que le tissu préimprégné est bidirectionnel(0°,90°).

10. Panneau composite monolithique ou de type sandwich organisé autour d'une âme, muni d'un blindage électromagnétique selon l'une des revendication 2 à 9, caractérisé en ce qu' au moins une partie, notamment extrêmité, de grillage est séparée de la dernière couche de constitution du panneau par une couche isolante (7).

11. Panneau composite monolithique ou de type sandwich organisé autour d'une âme, muni d'un blindage électromagnétique selon la revendication 10, caractérisé en ce que la couche isolante (7) est un adhésif autodémoulant tenant à la température de polymérisation du panneau composite.

12. Panneau composite monolithique ou de type sandwich organisé autour d'une âme, muni d'un blindage électromagnétique selon la revendication 10, caractérisé en ce que la couche isolante (7) est en mylar ou feutre.

13. Panneau composite monolithique ou de type sandwich organisé autour d'une âme, muni d'un blindage électromagnétique selon l'une des revendications 2 à 12, caractérisé en ce qu'il présente des raidisseurs munis de grillages métalliques pour le blindage électromagnétique.

14. Panneau composite monolithique ou de type sandwich organisé autour d'une âme, muni d'un blindage électromagnétique, selon la revendication 13, caractérisé en ce que les raidisseurs sont en matériau composite, intégrés au panneau par stratification au contact ou par collage.

15. Panneau composite monolithique ou de type sandwich organisé autour d'une âme, muni d'un blindage électromagnétique, selon l'une des revendications 13 ou 14, caractérisé en ce qu' au moins une partie, notamment extrêmité, de grillage est séparée de la dernière couche de constitution du raidisseur par une couche isolante.

16. Panneau composite monolithique ou de type sandwich organisé autour d'une âme, muni d'un blindage électromagnétique selon la revendication 15, caractérisé en ce que la couche isolante est un adhésif autodémoulant.

17. Panneau composite monolithique ou de type sandwich organisé autour d'une âme, muni d'un blindage électromagnétique selon la revendication 15, caractérisé en ce que la couche isolante est en mylar ou feutre.

18. Panneau composite monolithique ou de type sandwich organisé autour d'une âme, muni d'un blindage électromagnétique, selon l'une des revendications 15 à 17, caractérisé en ce que le grillage des raidisseurs est relié au grillage du panneau par pliage et soudage.

19. Panneau composite monolithique ou de type sandwich organisé autour d'une âme, muni d'un blindage électromagnétique selon l'une des revendications 10 à 18, caractérisé en ce qu' il est assemblé à un autre panneau composite monolithique ou de type sandwich organisé autour d'une âme, muni d'un blindage électromagnétique et situé dans le même plan, grâce à des couches supplémentaires de tissu préimprégné disposées en gradin (8) à la jonction, les extrémités des grillages des deux panneaux composites étant pliées et jointes par soudure (9).

20. Panneau composite monolithique ou de type sandwich organisé autour d'une âme, muni d'un blindage électromagnétique selon l'une des revendications 10 à 19, , caractérisé en ce qu' il est assemblé à un autre panneau composite monolithique ou de type sandwich organisé autour d'une âme, muni d'un blindage électromagnétique et situé dans un plan faisant un angle avec le plan du premier panneau, grâce à des couches supplémentaires de tissu préimprégné disposées en cornière (10) à la jonction, les extrêmités des grillages des deux panneaux composites étant pliées et jointes par soudure (9).

21. Application des panneaux selon l'une des revendications 2 à 20, au blindage électromagnétique de locaux techniques.
